# EUROPÄISCHE PATENTSCHRIFT

(11) **EP 2 629 421 B1**
(45) Veröffentlichungstag und Bekanntmachung des Hinweises auf die Patenterteilung: **07.11.2018**
(21) Anmeldenummer: 12000948.5
(22) Anmeldetag: 14.02.2012
(51) Int. Cl.: H03K 7/08

(54) **Verfahren zur Steuerung einer Pulsweitenmodulation mitttels eines Datenbusses**
Method for controlling pulse-with modulation by means of a data bus
Procédé de commande d'une modulation d'amplitudes d'impulsion à l'aide d'un bus de données

(43) Veröffentlichungstag der Anmeldung: 21.08.2013
(73) Patentinhaber: Delphi Technologies, Inc., Troy, MI 48007 (US)
(72) Erfinder: Wolf, Andreas, 51469 Bergisch Gladbach (DE); Zöller, Georg, 57578 Elkenroth (DE); Zimmermann, Eugen, 50389 Wesseling (DE); Beine, Dietmar, 51674 Wiehl (DE)
(74) Vertreter: Robert, Vincent

(56) Entgegenhaltungen:
- EP-A1- 1 983 399
- EP-A1- 1 983 400
- DE-A1- 19 620 207
- US-A- 6 094 079
- US-A1- 2002 181 577

## Beschreibung

Die vorliegende Erfindung betrifft ein Verfahren zur Steuerung einer Pulsweitenmodulation (PWM) mittels eines Datenbusses nach dem Oberbegriff des Anspruchs 1, umfassend eine Übertragung von Daten, welche Ein- und Ausschaltzeiten der PWM für zumindest einen PWM-Kanal steuern.

Verfahren zur Steuerung einer PWM sind grundsätzlich bekannt, wobei diese Verfahren auf einem kontinuierlichen Senden von Informationen beruhen. Das bedeutet, dass an jedem möglichen Zeitpunkt, an dem ein Ausgang der PWM umgeschaltet werden kann, ein Datentransfer ausgelöst wird.

Aus der EP 1 983 400 A1 ist ein Verfahren zur Steuerung einer PWM gemäß dem Oberbegriff des Anspruchs 1 bekannt. Die US 2002/0181577 A1 offenbart die Verwendung von Konfigurations-Bits zur Steuerung einer PWM. Weiterhin beschreibt die EP 1 983 399 A1, die Zeitpunkte von Pulsflanken einer PWM zeitlich versetzt anzuordnen und die Zeitpunkte in Listenform abzuspeichern. Ferner ist es aus der DE 196 20 207 A1 bekannt, die Breite eines PWM-Ausgangspulses anhand der Daten eines Datenbusses einzustellen.

Zur Steuerung einer PWM mit einer Frequenz von 100 Hz und 8 Bit Auflösung ist es beispielsweise notwendig, alle 39,06 µs einen Befehl an die PWM zu senden (1/100 s / 2⁸ = 0,01 s / 256 = 39,06 µs). Der notwendige Aufwand, um beispielsweise 256 Übertragungen in einer PWM-Periode durchzuführen, ist sehr hoch und resultiert in einer hohen Speicherauslastung, wenn z.B. ein Mikroprozessor zur Steuerung der PWM verwendet wird. Auch eine Recheneinrichtung (CPU) des Mikroprozessors wird durch die bekannten Verfahren sehr stark beansprucht, da für jede neue Übertragung beispielsweise ein Interrupt ausgelöst werden muss.

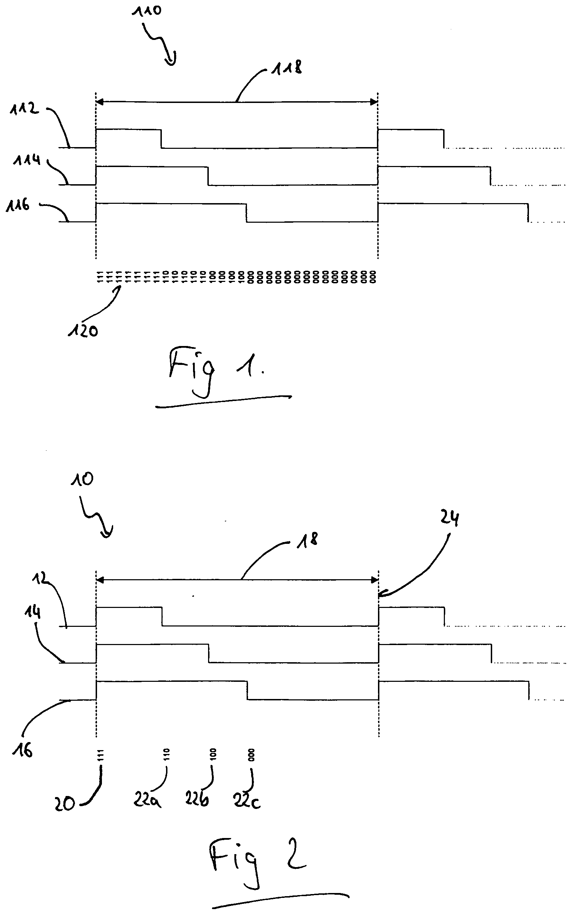

Beispielhaft sind in Fig. 1 in einem Timing-Diagramm 110 Signalverläufe 112, 114 und 116 dreier PWM-Kanälen gezeigt. Innerhalb einer PWM-Periode 118 werden ständig Steuersignale 120 an die PWM übertragen. Obwohl das in Fig. 1 gezeigt Beispiel nur drei PWM-Kanäle und 30 Übertragungen zeigt, ist deutlich zu erkennen, dass ständig Informationen gesendet werden, die teilweise redundant sind.

Zudem wird nachteiligerweise ein Übertragungskanal, über den die PWM gesteuert wird, durch die kontinuierliche Übertragung von PWM-Steuersignalen dauerhaft belegt und steht somit nicht mehr zur Übertragung von anderen Daten zur Verfügung. Auch kann eine dauerhafte Übertragung hochfrequenter Signale zu Problemen mit der elektromagnetischen Verträglichkeit (EMV) führen.

Es ist das der Erfindung zugrunde liegende Problem, ein Verfahren zur Steuerung einer Pulsweitenmodulation der eingangs genannten Art dahingehend weiterzubilden, dass eine möglichst einfache und wenig aufwendige Steuerung einer Pulsweitenmodulation ermöglicht wird.

Die Lösung dieser Aufgabe erfolgt durch die Merkmale der unabhängigen Ansprüche und insbesondere dadurch, dass in einer PWM-Periode zunächst ein Ein- oder ein Ausschaltsignal für einen PWM-Kanal übertragen wird, und dann ein Triggersignal zur Invertierung des PWM-Kanals an einem Schaltzeitpunkt in der PWM-Periode übertragen wird, wenn ein Zustand des PWM-Kanals invertiert werden soll, wobei mehrere PWM-Kanäle parallel durch das erfindungsgemäße Verfahren gesteuert werden und das Ein- oder Ausschaltsignal alle PWM-Kanäle synchronisiert ein- oder ausschaltet und wobei ferner für jeden Kanal das Triggersignal für eine Invertierung des Zustands des jeweiligen Kanals separat übertragen wird.

Somit ist es möglich, mittels eines Datenbusses mehrere PWM-Kanäle zu steuern. Auf diese Weise werden weitere Übertragungen eingespart, da das Ein- oder Ausschaltsignal für alle PWM-Kanäle gilt und somit nicht für jeden Kanal ein gesondertes Ein- oder Ausschaltsignal übertragen werden muss.

Zur Verdeutlichung sei hier noch einmal das einleitende Beispiel einer PWM mit einer Frequenz von 100 Hz und 8 Bit Auflösung sowie acht Kanälen angeführt, die erfindungsgemäß nur noch 9 Übertragungen statt 256 Übertragungen pro PWM-Periode benötigt (ein Ein- oder Ausschaltsignal sowie ein Triggersignal pro PWM-Kanal und PWM-Periode).

Mit der erfindungsgemäßen Lösung kann das kontinuierliche Übertragen von Daten an die PWM entfallen. Pro PWM-Periode muss mit dem erfindungsgemäßen Verfahren lediglich ein Ein- oder Ausschaltsignal gesendet werden, wobei anschließend lediglich ein Triggersignal zur Invertierung des PWM-Kanals an einem Schaltzeitpunkt in der PWM-Periode übertragen werden muss, an dem der Zustand des PWM-Kanals invertiert werden soll. Die Übertragung von redundanten Informationen, wie bei bekannten Verfahren, wird somit vermieden.

Durch die erfindungsgemäß deutlich verringerte übertragene Datenmenge verringert sich auch der Rechenaufwand zur Durchführung der Übertragungen deutlich, der Speicherverbrauch nimmt ab und es ist zudem möglich, Daten, die nicht zur Steuerung der PWM benötigt werden, zwischen den einzelnen Triggersignalen zu übertragen, da der Datenbus nun nicht ständig belegt ist. Weiterhin verbessert eine geringere Verwendung des Datenbusses dessen elektromagnetische Verträglichkeit (EMV).

Vorteilhafte Ausführungsformen der Erfindung sind in der Beschreibung, den Zeichnungen sowie den Unteransprüchen beschrieben.

Nach einer ersten vorteilhaften Ausführungsform kann der Datenbus ein serieller Datenbus, insbesondere ein SPI-(Serial-Peripheral-Interface) Bus sein. Der SPI-Bus ist insbesondere zur Datenkommunikation zwischen einzelnen elektronischen Bauteilen ausgelegt und somit einfach zu implementieren. Er bietet sich deshalb besonders dafür an, eine PWM zu steuern, da er standardmäßig von vielen elektronischen Bauteilen unterstützt wird.

Der SPI-Bus umfasst in der Regel auch eine sog. Chip-Select-Leitung (CS), über die verschiedene Empfänger ausgewählt werden können. Auf diese Weise können neben der PWM auch noch andere Bauteile angesteuert werden, insbesondere in den Zeiten, in denen kein Triggersignal an die PWM übertragen werden muss. Alternativ können auch mehrere PWMs angesteuert werden, die dann entsprechend über ihre CS-Leitung ausgewählt werden.

Gemäß einer weiteren vorteilhaften Ausführungsform kann das Verfahren von einem elektronischen Bauteil, insbesondere von einem Mikroprozessor, ausgeführt werden. Dies ist insbesondere von Vorteil, da beispielsweise Mikroprozessoren bereits über die notwendigen Ausgänge zur Steuerung eines Datenbusses, insbesondere eines SPI-Busses, verfügen und in der Regel auch durch ihre Signalpegel (z.B. TTL: 5 V) mit den für eine PWM-Steuerung benötigten weiteren elektronischen Bauteilen kompatibel sind.

Gemäß einer weiteren vorteilhaften Ausführungsform kann das elektronische Bauteil eine Timer-Interrupt-Routine verwenden, die einen Interrupt auslösen kann, um den Schaltzeitpunkt zur Übertragung des Triggersignals zu ermitteln und nach einem Auslösen des Interrupts das Triggersignal zu übertragen.

Die Verwendung einer Timer-Interrupt-Routine verringert die benötigte Rechenleistung in dem elektronischen Bauteil, insbesondere in dem Mikroprozessor, da ein (Timer-) Interrupt in dem elektronischen Bauteil zu einem vorgegebenen Zeitpunkt ausgeführt wird und dann das Triggersignal übertragen werden kann. Anschließend kann das elektronische Bauteil mit seiner ursprünglichen Aufgabe fortfahren. Der Vorteil eines (Timer-) Interrupts ist es also, dass in einem normalen Programmablauf des elektronischen Bauteils nicht wiederholt überprüft werden muss, ob der Zeitpunkt zum Senden des Triggersignals bereits erreicht ist.

Gemäß einer weiteren vorteilhaften Ausführungsform kann nach dem Auslösen des Interrupts ein neuer Schaltzeitpunkt, der den Schaltzeitpunkt einer nächsten Übertragung des Triggersignals beschreibt und in einem ersten Speicher gespeichert ist, in einen Timerspeicher der Timer-Interrupt-Routine geladen werden. Die Timer-Interrupt-Routine kann den Zeitpunkt, an dem sie einen Interrupt auslöst, dadurch ermitteln, dass sie eine aktuelle Zeit mit einem Schaltzeitpunkt der in einem Timerspeicher der Timer-Interrupt-Routine gespeichert sein kann, vergleicht. Vorteilhafterweise kann nach dem Auslösen eines Interrupts sofort der nächste Schaltzeitpunkt in den Timerspeicher geladen werden, der in dem ersten Speicher gespeichert sein kann und somit nicht aufwendig während des Interrupts berechnet werden muss.

Gemäß einer weiteren vorteilhaften Ausführungsform kann nach dem Auslösen des Interrupts ein Ausgangszustand, der in einem zweiten Speicher gespeichert ist, an einen Ausgang des elektronischen Bauteils ausgegeben werden. Somit können durch den Interrupt gleichzeitig auch Ausgänge des elektronischen Bauteils gesteuert werden und insbesondere in einen Zustand gebracht werden, der in dem zweiten Speicher gespeichert ist.

Gemäß einer weiteren vorteilhaften Ausführungsform kann nach dem Auslösen des Interrupts ein Befehl, der in einem dritten Speicher gespeichert ist, mittels des Datenbusses übertragen werden. Die Übertragung der Ein- oder Ausschaltsignale bzw. der Triggersignale kann also durch einen Interrupt ausgelöst werden. Wie voranstehend ausgeführt, verringert die Verwendung eines Interrupts die benötigte Rechenleistung zur Durchführung der Übertragung. Somit kann das erfindungsgemäße Verfahren ohne einen großen Ressourcenverbrauch durchgeführt werden.

Gemäß einer weiteren vorteilhaften Ausführungsform können die Schaltzeitpunkte, an denen eine Übertragung von Triggersignalen stattfinden soll, in einer ersten und einer zweiten Tabelle in dem ersten Speicher des elektronischen Bauteils gespeichert sein. Die erste Tabelle kann durch die zweite Tabelle ersetzt werden, sobald die erste Tabelle abgearbeitet ist.

Um die Schaltzeitpunkte nicht zur Laufzeit berechnen zu müssen, können diese in dem ersten Speicher des elektronischen Bauteils abgelegt sein. In dem ersten Speicher können eine erste und eine zweite Tabelle mit Schaltzeitpunkten angelegt sein, wobei zunächst die erste Tabelle abgearbeitet wird, während die zweite Tabelle im Hintergrund berechnet und angelegt wird. Um eine Steuerung der PWM nach dem Erreichen eines Endes der ersten Tabelle nicht unterbrechen zu müssen, kann dann die zweite Tabelle die erste ersetzen, wodurch eine schnelle Umschaltung auf die weiteren Schaltzeitpunkte gewährleistet werden kann. Vorteilhafterweise kann die Durchführung des erfindungsgemäßen Verfahrens somit ohne Unterbrechung erfolgen, insbesondere, wenn für einen Zugriff auf die erste Tabelle ein Direktspeicherzugriff (DMA) verwendet wird. Die Verwendung von Interrupts und Direktspeicherzugriffen kann weitere Vorteile bieten, da abhängig von dem verwendeten elektronischen Bauteil zur Ausführung des erfindungsgemäßen Verfahrens im besten Fall nur ein Interrupt in einer PWM-Periode benötigt wird.

Gemäß einer weiteren vorteilhaften Ausführungsform kann eine Umschaltung zwischen der ersten und der zweiten Tabelle zwischen den zwei Schaltzeitpunkten der ersten Tabelle erfolgen, die den größten zeitlichen Abstand aufweisen. Die notwendige Umschaltung zwischen der ersten und zweiten Tabelle kann also in einem Zeitintervall erfolgen, in dem das elektronische Bauteil für längere Zeit nicht mit der Steuerung der PWM beschäftigt ist. Auf diese Weise kann eine Beeinflussung der Steuerung der PWM vermieden werden.

Gemäß einer weiteren vorteilhaften Ausführungsform können absolute Zeitstempel für ein Speichern der Schaltzeitpunkte verwendet werden. Durch die Verwendung absoluter Zeitstempel wird die zeitliche Ungenauigkeit der Schaltzeitpunkte eliminiert, weiterhin ist es möglich, zu überprüfen, ob die Timer-Interrupt-Routine bzw. der Direktspeicherzugriff (DMA) zum richtigen Zeitpunkt ausgelöst wurden. Wird erkannt, dass die Timer-Interrupt-Routine bzw. der Direktspeicherzugriff (DMA) zu spät ausgelöst wurden, können diese neu synchronisiert werden.

Gemäß einer weiteren vorteilhaften Ausführungsform können Triggersignale für verschiedene PWM-Kanäle, die zeitlich näher zusammenliegen als ein vorbestimmter Schwellenwert, zu einem Triggersignal zusammengefasst werden. Da das Übertragen eines Triggersignals und die Ausführung des Interrupts eine gewisse Zeit benötigen, kann es vorkommen, dass das nächste Triggersignal bereits gesendet werden müsste, während das vorhergehende Triggersignal gerade noch gesendet wird. In einem solchen Fall ist es vorteilhaft, beide Triggersignale zu einem zusammenzufassen, wobei das eine Triggersignal dann mehrere PWM-Kanäle invertieren kann. Auf diese Weise wird zudem die Rechenleistung eingespart, die benötigt würde, um das nächste Triggersignal zu senden. Weiterhin wird die elektromagnetische Verträglichkeit erhöht, da der Datenbus weniger lange verwendet wird.

Gemäß einer weiteren vorteilhaften Ausführungsform kann der Datenbus in Zeitintervallen zwischen der Übertragung von Triggersignalen Daten übertragen, die nicht für die Steuerung der PWM benötigt werden. Somit kann der Datenbus besser ausgenutzt werden, da er nicht mehr allein für die Steuerung der PWM verwendet werden muss, sondern auch andere Einrichtungen mit Daten versorgen kann.

Die Erfindung bezieht sich weiterhin auf eine Vorrichtung zur Steuerung einer Pulsweitenmodulation mittels eines Datenbusses, insbesondere zur Durchführung des obigen Verfahrens, aufweisend ein elektronisches Bauteil, insbesondere einen Mikroprozessor, welches Ausgänge für einen Datenbus umfasst, der eine Übertragung von Daten, die eine Steuerung von Ein- und Ausschaltzeiten einer Pulsweitenmodulation (PWM) für zumindest einen PWM-Kanal ermöglichen aufweist, wobei das elektronische Bauteil mittels des Datenbusses in der PWM-Periode zunächst ein Ein- oder ein Ausschaltsignal für den PWM-Kanal überträgt und dann ein Triggersignal zur Invertierung des PWM-Kanals an einem Schaltzeitpunkt in der PWM-Periode überträgt, wenn ein Zustand des PWM-Kanals invertiert werden soll, wobei das elektronische Bauteil mehrere PWM-Kanäle parallel steuert, das Ein- oder Ausschaltsignal alle PWM-Kanäle synchronisiert ein- oder ausschaltet und ferner für jeden Kanal das Triggersignal für eine Invertierung des Zustands des jeweiligen Kanals separat überträgt.

Gemäß einer weiteren vorteilhaften Ausführungsform kann das elektronische Bauteil Ausgänge für einen seriellen Datenbus, insbesondere einen SPI-Bus umfassen und damit eine Schnittstelle aufweisen, die vorteilhafterweise zu vielen elektronischen Bauteilen kompatibel ist.

Nachfolgend wird die Erfindung rein beispielhaft anhand möglicher Ausführungsformen unter Bezugnahme auf die beigefügten Zeichnungen beschrieben. Es zeigen in schematischer Darstellung:
- Fig. 1: Signalverläufe sowie Datenübertragungen zur Steuerung einer dreikanaligen Pulsweitenmodulation (PWM) gemäß einem Verfahren nach dem Stand der Technik;
- Fig. 2: Signalverläufe sowie die Datenübertragung zur Steuerung einer dreikanaligen Pulsweitenmodulation (PWM) gemäß dem erfindungsgemäßen Verfahren;
- Fig. 3: einen Ablauf, der eine Ausführung des erfindungsgemäßen Verfahrens in einem elektronischen Bauteil zeigt.

In Fig. 2 ist ein Timing-Diagramm 10 dargestellt, das Signalverläufe von drei Kanälen einer Pulsweitenmodulation (PWM) zeigt. Dargestellt sind ein Signalverlauf eines ersten PWM-Kanals 12, der einen Duty Cycle von 23 % aufweist, ein Signalverlauf 14 eines zweiten PWM-Kanals mit einem Duty Cycle von 40 % sowie ein Signalverlauf eines dritten PWM-Kanals 16, der einen Duty Cycle von 53 % aufweist. Eine Länge einer PWM-Periode 18 ist durch einen Pfeil dargestellt.

Zu Beginn der PWM-Periode 18 wird zunächst ein Einschaltsignal 20 übertragen, das alle drei Kanäle synchron einschaltet. Danach werden zu bestimmten Zeitpunkten innerhalb der PWM-Periode 18 Triggersignale 22a, 22b und 22c übertragen, die jeweils einen einzelnen Kanal invertieren, und somit ausschalten. Das Triggersignal 22a ist dem ersten Kanal zugeordnet und wird zeitlich als erstes übertragen, da der erste PWM-Kanal den kleinsten Duty Cycle aufweist, dementsprechend wird das Triggersignal 22b als zweites übertragen. Das Triggersignal 22c ist dem dritten PWM-Kanal zugeordnet und wird zeitlich zuletzt übertragen, da dieser PWM-Kanal den größten Duty Cycle aufweist und somit am längsten eingeschaltet ist. Nach dem Senden des letzten Triggersignals (22c) bleiben alle PWM-Kanäle bis zum Ende der PWM-Periode 18 unverändert und somit ausgeschaltet.

Ein Beginn einer zweiten PWM-Periode 24 wird wieder durch die Übertragung eines (nicht dargestellten) zweiten Einschaltsignals gekennzeichnet. Im Anschluss an das zweite Einschaltsignal wiederholen sich die Vorgänge wie in PWM-Periode 18.

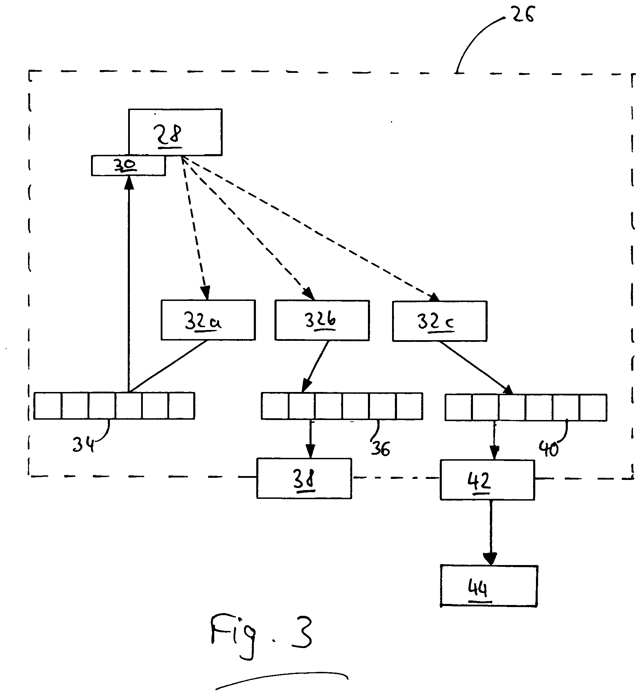

Fig. 3 zeigt die Vorgänge, die zur Ausführung des erfindungsgemäßen Verfahrens in einem Mikroprozessor 26 notwendig sind. Der Mikroprozessor 26 weist eine Timer-Interrupt-Routine 28 auf, die ein Vergleichsregister 30 umfasst. In dem Vergleichsregister 30 ist ein Zeitpunkt zum nächsten Auslösen eines Interrupts durch die Timer-Interrupt-Routine 28 als absoluter Zeitstempel gespeichert. Ergibt der Vergleich einer momentanen Zeit mit der in dem Vergleichsregister 30 gespeicherten Zeit, dass ein Interrupt ausgelöst werden soll, so werden durch den Interrupt drei Direktspeicherzugriffe 32a, 32b und 32c (DMAs) ausgelöst.

Der erste Direktspeicherzugriff 32a greift dabei auf einen ersten Speicher 34 des Mikroprozessors 26 zu, wobei in dem ersten Speicher 34 Schaltzeitpunkte zur Auslösung der Timer-Interrupt-Routine 28 in zwei (nicht gezeigten) Tabellen gespeichert sind. Durch den Direktspeicherzugriff 32a wird der nächste Schaltzeitpunkt aus dem ersten Speicher 34 in das Vergleichsregister 30 geladen. Die Timer-Interrupt-Routine 28 löst also erst wieder einen Interrupt aus, wenn der neu in das Vergleichsregister 30 geladene Schaltzeitpunkt erreicht ist.

Der zweite Direktspeicherzugriff 32b veranlasst, dass aus einem zweiten Speicher 36 ein Ausgangszustand für Ausgänge des Mikroprozessors 26 an einen Ausgang 38 des Mikroprozessors 26 ausgegeben wird. Auf diese Weise wird an dem Zeitpunkt, an dem die Timer-Interrupt-Routine 28 einen Interrupt auslöst, auch eine Ausgangskonfiguration des Mikroprozessors verändert.

Der dritte Direktspeicherzugriff 32c greift auf einen dritten Speicher 40 zu, in dem ein Befehl gespeichert ist, der mittels eines SPI-Busses 42 übertragen wird. Der Befehl wird von dem dritten Speicher 40 an den SPI-Bus 42 des Mikroprozessors übermittelt und durch den SPI-Bus 42 an eine Pulsweitenmodulation (PWM) 44 übertragen. Bei dem Befehl kann es sich um ein Triggersignal aber auch um ein Ein- oder Ausschaltsignal handeln, das am Anfang einer PWM-Periode 18 gesendet wird.

Bei einer fortdauernden Verwendung des erfindungsgemäßen Verfahrens erfolgt zyklisch ein Auslösen der Timer-Interrupt-Routine 28, wodurch aus dem dritten Speicher 40 ein Befehl ausgelesen wird, der mittels des SPI-Busses 42 an die PWM 44 übertragen wird. Ebenfalls wird aus dem ersten Speicher 34 der nächste Schaltzeitpunkt in das Vergleichsregister 30 der Timer-Interrupt-Routine 28 geladen, wodurch die Timer-Interrupt-Routine 28 zu dem nächsten Zeitpunkt wieder ausgelöst wird und den nächsten Befehl aus dem dritten Speicher 40 mittels des SPI-Busses 42 an die PWM 44 überträgt. Diese Vorgänge können beliebig oft wiederholt werden.

### Bezugszeichenliste

- 10: Timing-Diagramm
- 12: Signalverlauf des ersten PWM-Kanals
- 14: Signalverlauf des zweiten PWM-Kanals
- 16: Signalverlauf des dritten PWM-Kanals
- 18: PWM-Periode
- 20: Einschaltsignal
- 20a, 20b, 20c: Triggersignale
- 24: zweite PWM-Periode
- 26: Mikroprozessor
- 28: Timer-Interrupt-Routine
- 30: Vergleichsregister
- 32a, 32b, 32c: Direktspeicherzugriffe
- 34: erster Speicher
- 36: zweiter Speicher
- 38: Ausgang
- 40: dritter Speicher
- 42: SPI-Bus
- 44: Pulsweitenmodulation (PWM)
- 110: Timing-Diagramm
- 112: Signalverlauf des ersten PWM-Kanals
- 114: Signalverlauf des zweiten PWM-Kanals
- 116: Signalverlauf des dritten PWM-Kanals
- 118: PWM-Periode
- 120: Steuersignale

## Patentansprüche

1. Verfahren zur Steuerung einer Pulsweitenmodulation (PWM) mittels eines Datenbusses, umfassend
eine Übertragung von Daten, welche Ein- und Ausschaltzeiten der PWM für zumindest einen PWM-Kanal steuern, wobei
in einer PWM-Periode zunächst ein Ein- oder ein Ausschaltsignal für den PWM-Kanal übertragen wird, und
dann ein Triggersignal zur Invertierung des PWM-Kanals an einem Schaltzeitpunkt in der PWM-Periode übertragen wird, wenn ein Zustand des PWM-Kanals invertiert werden soll,
**dadurch gekennzeichnet, dass**
mehrere PWM-Kanäle parallel gesteuert werden, wobei das Ein- oder Ausschaltsignal alle PWM-Kanäle synchronisiert ein- oder ausschaltet und wobei ferner für jeden Kanal das Triggersignal für eine Invertierung des Zustands des jeweiligen Kanals separat übertragen wird.

2. Verfahren nach Anspruch 1,
**dadurch gekennzeichnet, dass**
der Datenbus ein serieller Datenbus, insbesondere ein SPI-(Serial Peripheral Interface) Bus, ist.

3. Verfahren nach zumindest einem der vorstehenden Ansprüche,
**dadurch gekennzeichnet, dass**
das Verfahren von einem elektronischen Bauteil, insbesondere einem Mikroprozessor, ausgeführt wird.

4. Verfahren nach Anspruch 3,
**dadurch gekennzeichnet, dass**
das elektronische Bauteil eine Timer-Interrupt-Routine verwendet, die einen Interrupt auslösen kann, um den Schaltzeitpunkt zur Übertragung des Triggersignals zu ermitteln und dass nach einem Auslösen des Interrupts durch die Timer-Interrupt-Routine das Triggersignal übertragen wird.

5. Verfahren nach Anspruch 4,
**dadurch gekennzeichnet, dass**
nach dem Auslösen des Interrupts ein neuer Schaltzeitpunkt, der den Schaltzeitpunkt einer nächsten Übertragung des Triggersignals beschreibt und in einem ersten Speicher gespeichert ist, in einen Timer-Speicher der Timer-Interrupt-Routine geladen wird.

6. Verfahren nach Anspruch 4 oder 5,
**dadurch gekennzeichnet, dass**
nach dem Auslösen des Interrupts ein Ausgangszustand, der in einem zweiten Speicher gespeichert ist, an einen Ausgang des elektronischen Bauteils ausgegeben wird.

7. Verfahren nach Anspruch 4, 5 oder 6,
**dadurch gekennzeichnet, dass**
nach dem Auslösen des Interrupts ein Befehl, der in einem dritten Speicher gespeichert ist, mittels des Datenbusses übertragen wird.

8. Verfahren nach Anspruch 4, 5, 6 oder 7,
**dadurch gekennzeichnet, dass**
die Schaltzeitpunkte, an denen eine Übertragung von Triggersignalen stattfinden soll, in einer ersten und einer zweiten Tabelle in dem ersten Speicher des elektronischen Bauteils gespeichert sind und die erste Tabelle durch die zweite Tabelle ersetzt wird, sobald die erste Tabelle abgearbeitet ist.

9. Verfahren nach Anspruch 8,
**dadurch gekennzeichnet , dass**
eine Umschaltung zwischen der ersten und der zweiten Tabelle zwischen den zwei Schaltzeitpunkten der ersten Tabelle erfolgt, die den größten zeitlichen Abstand aufweisen.

10. Verfahren nach einem der vorstehenden Ansprüche,
**dadurch gekennzeichnet, dass**
absolute Zeitstempel für ein Speichern der Schaltzeitpunkte verwendet werden.

11. Verfahren nach einem der vorstehenden Ansprüche,
**dadurch gekennzeichnet, dass**
Triggersignale für verschiedene PWM-Kanäle, die zeitlich näher zusammenliegen als ein vorbestimmter Schwellenwert, zu einem Triggersignal zusammengefasst werden.

12. Verfahren nach einem der vorstehenden Ansprüche,
**dadurch gekennzeichnet, dass**
der Datenbus in Zeitintervallen zwischen der Übertragung von Triggersignalen Daten überträgt, die nicht für die Steuerung der PWM benötigt werden.

13. Vorrichtung zur Steuerung einer Pulsweitenmodulation (PWM) mittels eines Datenbusses, insbesondere zur Durchführung des Verfahrens nach einem der vorstehenden Ansprüche, aufweisend
ein elektronisches Bauteil, insbesondere einen Mikroprozessor, welches Ausgänge für einen Datenbus umfasst, der eine Übertragung von Daten, die eine Steuerung von Ein- und Ausschaltzeiten einer Pulsweitenmodulation (PWM) für zumindest einen PWM-Kanal ermöglichen, wobei
das elektronische Bauteil mittels des Datenbusses in einer PWM-Periode zunächst ein Ein- oder ein Ausschaltsignal für den PWM-Kanal überträgt und dann ein Triggersignal zur Invertierung des PWM-Kanals an einem Schaltzeitpunkt in der PWM-Periode überträgt, wenn ein Zustand des PWM-Kanals invertiert werden soll, **dadurch gekennzeichnet, dass**
das elektronische Bauteil mehrere PWM-Kanäle parallel steuert, das Ein- oder Ausschaltsignal alle PWM-Kanäle synchronisiert ein- oder ausschaltet und ferner für jeden Kanal das Triggersignal für eine Invertierung des Zustands des jeweiligen Kanals separat überträgt.

14. Vorrichtung nach Anspruch 13,
**dadurch gekennzeichnet, dass**
das elektronische Bauteil Ausgänge für einen seriellen Datenbus, insbesondere einen SPI-(Serial Peripheral Interface) Bus, umfasst.

## Claims

1. Method for controlling a pulse width modulation (PWM) by means of a data bus, comprising
transmission of data for controlling on and off times of the PWM for at least one PWM channel, wherein
in a PWM period, first an on or an off signal for the PWM channel is transmitted, and
then a trigger signal for inverting the PWM channel is transmitted at a switching time in the PWM period when a state of the PWM channel is to be inverted, **characterized in that**
a plurality of PWM channels are controlled in parallel, wherein the on or off signal switches all PWM channels on or off in a synchronized way and further wherein for each channel the trigger signal for an inversion of the state of the respective channel is transmitted separately.

2. Method according to claim 1,
**characterized in that**
the data bus is a serial data bus, in particular a SPI (Serial Peripheral Interface) bus.

3. Method according to at least one of the preceding claims,
**characterized in that**
the method is executed by an electronic component, in particular a microprocessor.

4. Method according to claim 3,
**characterized in that**
the electronic component uses a timer interrupt routine which can trigger an interrupt to determine the switching time for transmitting the trigger signal, and **in that** the trigger signal is transmitted after triggering of the interrupt by the timer interrupt routine.

5. Method according to claim 4,
**characterized in that**
after triggering of the interrupt, a new switching time, which describes the switching time of a next transmission of the trigger signal and is stored in a first memory, is loaded into a timer memory of the timer interrupt routine.

6. Method according to claim 4 or 5,
**characterized in that**
after triggering of the interrupt, an output state which is stored in a second memory is output to an output of the electronic component.

7. Method according to claim 4, 5 or 6,
**characterized in that**
after triggering of the interrupt, a command which is stored in a third memory is transmitted by means of the data bus.

8. Method according to claim 4, 5, 6 or 7,
**characterized in that**
the switching times at which transmission of trigger signals is to occur are stored in a first and a second table in the first memory of the electronic component and the first table is replaced by the second table as soon as the first table has been processed.

9. Method according to claim 8,
**characterized in that**
a switching between the first and the second table occurs between the two switching times of the first table, which have the greatest time interval.

10. Method according to one of the preceding claims,
**characterized in that**
absolute time stamps are used for storing the switching times.

11. Method according to one of the preceding claims,
**characterized in that**
trigger signals for different PWM channels, which are closer together in time than a predetermined threshold, are combined into one trigger signal.

12. Method according to one of the preceding claims,
**characterized in that**
the data bus transmits data which are not required for control of the PWM at time intervals between the transmission of trigger signals.

13. Apparatus for controlling a pulse width modulation (PWM) by means of a data bus, in particular for carrying out the method according to one of the preceding claims, comprising
an electronic component, in particular a microprocessor, comprising outputs for a data bus which transmission of data enabling control of on and off times of a pulse width modulation (PWM) for at least one PWM channel, wherein
the electronic component using the data bus in a PWM period first transmits an on or an off signal for the PWM channel and then transmits a trigger signal for inverting the PWM channel at a switching time in the PWM period when a state of the PWM channel is to be inverted,
**characterized in that**
the electronic component controls a plurality of PWM channels in parallel, the on or off signal switches all PWM channels on or off in a synchronized way and further for each channel transmits separately the trigger signal for an inversion of the state of the respective channel.

14. Apparatus according to Claim 13,
**characterized in that**
the electronic component comprises outputs for a serial data bus, in particular a SPI (Serial Peripheral Interface) bus.

## Revendications

1. Procédé de commande d'une modulation de largeur d'impulsion (PWM) au moyen d'un bus de données, comprenant
une transmission de données qui commandent des temps d'activation et de désactivation de la PWM pour au moins un canal de PWM, dans lequel,
dans une période de PWM, un signal de d'activation ou de désactivation pour le canal de PWM est d'abord transmis, et
ensuite un signal de déclenchement pour inverser le canal de PWM est transmis à un instant de commutation dans la période de PWM lorsqu'un état du canal de PWM doit être inversé,
**caractérisé en ce que**
plusieurs canaux de PWM sont commandés en parallèle, le signal d'activation ou de désactivation activant ou désactivant tous les canaux de PWM de manière synchronisée et le signal de déclenchement pour une inversion de l'état du canal respectif étant transmis séparément pour chaque canal.

2. Procédé selon la revendication 1,
**caractérisé en ce que**
le bus de données est un bus de données série, en particulier un bus SPI (Serial Peripheral Interface).

3. Procédé selon au moins l'une des revendications précédentes, **caractérisé en ce que**
le procédé est mis en oeuvre par un composant électronique, en particulier un microprocesseur.

4. Procédé selon la revendication 3,
**caractérisé en ce que**
le composant électronique utilise une routine d'interruption de timer qui peut déclencher une interruption pour déterminer l'instant de commutation pour la transmission du signal de déclenchement et que le signal de déclenchement est transmis après que l'interruption a été déclenchée par la routine d'interruption de timer.

5. Procédé selon la revendication 4,
**caractérisé en ce que**
après le déclenchement de l'interruption, un nouvel instant de commutation, qui décrit l'instant de commutation d'une prochaine transmission du signal de déclenchement et qui est stocké dans une première mémoire, est chargé dans une mémoire de timer de la routine d'interruption de timer.

6. Procédé selon la revendication 4 ou 5,
**caractérisé en ce que**
après le déclenchement de l'interruption, un état de sortie, qui est stocké dans une deuxième mémoire, est délivré à une sortie du composant électronique.

7. Procédé selon la revendication 4, 5 ou 6,
**caractérisé en ce que**
après le déclenchement de l'interruption, un ordre qui est stocké dans une troisième mémoire est transmis au moyen du bus de données.

8. Procédé selon la revendication 4, 5, 6 ou 7,
**caractérisé en ce que**
les instants de commutation auxquels les signaux de déclenchement doivent être transmis sont stockés dans une première et une deuxième table dans la première mémoire du composant électronique et la première table est remplacée par la deuxième table dès que la première table a été traitée.

9. Procédé selon la revendication 8,
**caractérisé en ce**
**qu'**une commutation a lieu entre la première et la deuxième table entre les deux instants de commutation de la première table qui présentent la plus grande distance temporelle.

10. Procédé selon l'une des revendications précédentes,
**caractérisé en ce que**
des horodatages absolus sont utilisés pour un stockage des instants de commutation.

11. Procédé selon l'une des revendications précédentes,
**caractérisé en ce que**
les signaux de déclenchement pour différents canaux de PWM qui sont plus proches l'un de l'autre dans le temps qu'une valeur seuil prédéterminée sont combinés en un signal de déclenchement.

12. Procédé selon l'une des revendications précédentes,
**caractérisé en ce que**
dans les intervalles de temps entre la transmission de signaux de déclenchement, le bus de données transmet des données qui ne sont pas nécessaires pour la commande de la PWM.

13. Dispositif de commande d'une modulation de largeur d'impulsion (PWM) au moyen d'un bus de données, en particulier pour mettre en oeuvre le procédé selon l'une des revendications précédentes, présentant un composant électronique, en particulier un microprocesseur, qui comprend des sorties pour un bus de données qui présente une transmission de données qui permet une commande de temps d'activation et de désactivation d'une modulation de largeur d'impulsion (PWM) pour au moins un canal de PWM, dans lequel
le composant électronique transmet d'abord un signal d'activation ou de désactivation pour le canal de PWM au moyen du bus de données dans une période de PWM et transmet ensuite un signal de déclenchement pour inverser le canal de PWM à un instant de commutation dans la période de PWM lorsqu'un état du canal de PWM doit être inversé,
**caractérisé en ce que**
le composant électronique commande plusieurs canaux de PWM en parallèle, le signal d'activation ou de désactivation active ou désactive tous les canaux de PWM de manière synchronisée et transmet en outre séparément pour chaque canal le signal de déclenchement pour une inversion de l'état du canal respectif.

14. Dispositif selon la revendication 13,
**caractérisé en ce que**
le composant électronique comprend des sorties pour un bus de données série, en particulier un bus SPI (Serial Peripheral Interface).
